# EUROPEAN PATENT APPLICATION

(11) **EP 0 603 477 A1**
(43) Date of publication of application: **29.06.1994**
(21) Application number: 93115478.5
(22) Date of filing: 24.09.1993
(51) Int. Cl.: C23C 16/40, C23C 16/02, H01L 21/316

(54) **Method of forming a dielectric layer**

(30) Priority: 23.11.1992 US 980040
(71) Applicant: MOTOROLA, INC., Schaumburg, IL 60196 (US)
(72) Inventor: Ehlert, Eric P., Mesa, Arizona 85204 (US); Grivna, Gordon, Mesa, Arizona 85210 (US); Shin, Hank Hyun-Kyoo, Gilbert, Arizona 85234 (US)
(74) Representative: Hudson, Peter David

(57) **Abstract**

A method of forming a dielectric layer (19, 21, 22) provides the dielectric layer (19, 21, 22) with a substantially uniform density. A plasma of an activation gas (16) is formed wherein the activation gas plasma is substantially devoid of other gases. The plasma of the activation gas (16) is maintained until the plasma becomes stable. After stabilization is achieved, dielectric formation is initiated by adding a dielectric precursor gas (18) to the plasma of the activation gas thereby forming a plasma of the dielectric precursor gas.

## Description

The present invention relates, in general, to semiconductor processing, and more particularly, to a novel method of forming a dielectric layer.

Previously, the semiconductor industry has utilized a variety of methods for forming dielectric layers on semiconductor wafers. One problem resulting from these previous methods is the dielectric's density. During the dielectric's formation, the portion of the dielectric that is formed first often has a lower density than the subsequently formed portions. Consequently, the dielectric's density varies throughout the dielectric's thickness. During etching operations, the lower density portions of the dielectric etch at a much higher rate than the higher density portions. Therefore, the etching generally proceeds laterally through the dielectric's low density portion thereby undercutting the high density portion of the dielectric layer. As subsequently applied conductor layers traverse the discontinuity created by the undercut, the discontinuity causes thin areas or even openings in the conductor layer thereby diminishing the conductor's current carrying capability.

Accordingly, it is desirable to have a dielectric layer that has a substantially constant density throughout the layer, and that etches at a substantially constant rate throughout the layer.

### Summary of the Invention

Briefly stated, the present invention includes a method of forming a dielectric layer having a substantially uniform density throughout the dielectric layer. A plasma of an activation gas is formed wherein the plasma is substantially devoid of other gases. The plasma of the activation gas is maintained until the plasma becomes stable. Subsequently, a plasma of a dielectric precursor gas is formed by adding the dielectric precursor gas to the plasma of the activation gas.

### Brief Description of the Drawings

Fig. 1 illustrates a portion of a deposition chamber in accordance with the present invention; and
FIG. 2 illustrates an enlarged cross-sectional portion of a semiconductor wafer having a dielectric layer in accordance with the present invention.

### Detailed Description of the Drawings

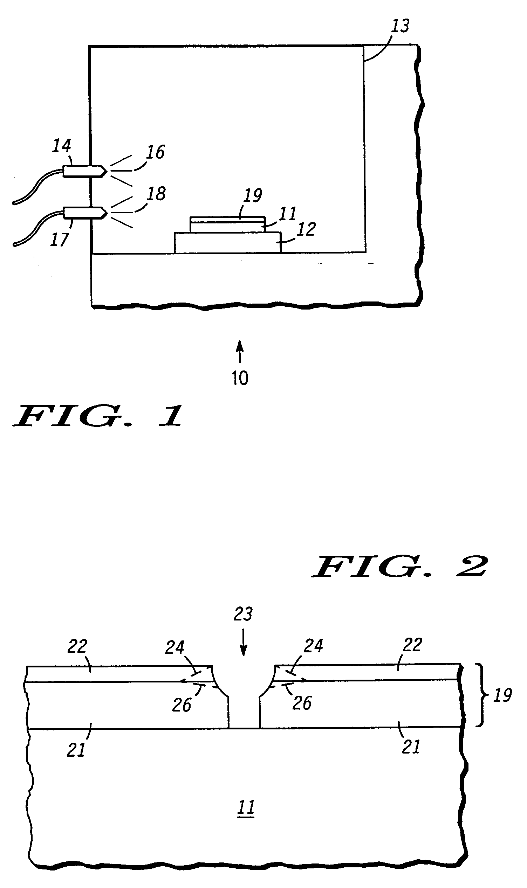

FIG. 1 illustrates a portion of a deposition reactor 10 that is suitable for forming dielectric layers by chemical vapor deposition (CVD), plasma enhanced chemical vapor deposition (PECVD), and other similar means. Reactor 10 has a deposition chamber 13 wherein an ionized plasma is formed in order to facilitate depositing a dielectric layer 19 onto a semiconductor wafer 11. A platform 12 within chamber 13 assists in maintaining wafer 11 in a desired position. Wafer 11 may be a bare silicon wafer, or may have a previously formed dielectric layer on the surface of wafer 11. In the preferred embodiment, wafer 11 is a silicon wafer that has a silicon dioxide layer previously formed thereon.

It has been found that the density of a dielectric layer varies from a low density during the initial stages of dielectric formation to a higher density during later stages of the formation. It has also been found that the density is related to the stability of the plasma used during dielectric formation. If the plasma is stabilized before initiation of the dielectric deposition, the dielectric density will be substantially constant throughout the thickness of the dielectric.

In order to form layer 19 on wafer 11, chamber 13 is first evacuated to create a vacuum, generally less than fifty millitorr. In the preferred embodiment, a vacuum pressure of less than approximately nine torr is used. An activation gas 16 is released into chamber 13 through an activation gas inlet 14. Reactor 10 is then energized to initiate a plasma of activation gas 16. Upon initialization, only a small portion of gas 16 is activated, but the plasma is allowed to spread until a stabilization point is reached wherein substantially all of gas 16 within chamber 13 is ionized. In the preferred embodiment, the plasma is maintained for approximately two seconds in order to achieve stabilization. Thereafter, a precursor gas 18 of the desired dielectric is released into chamber 13 through a gas inlet 17. Typically, the precursor gas and the activation gas are chosen together to provide a plasma that results in a desired dielectric material. Typical combinations used to provide a silicon dioxide dielectric include oxygen as the activation gas and tetraethylorthosilicate (TEOS) as the precursor gas, or nitrous oxide as the activation gas along with silane as the precursor gas.

After precursor gas 18 is released, deposition of dielectric 19 onto wafer 11 begins. Deposition is continued until a desired thickness is achieved. The resulting dielectric 19 has a substantially constant density throughout the thickness of dielectric 19.

In the preferred embodiment, a silicon dioxide dielectric is formed by using oxygen as the activation gas and TEOS as the precursor gas. Gas 18 is released at a rate between approximately 100 and 300 cubic centimeters/second to form a TEOS plasma that produces silicon dioxide at a rate between 7800 and 8200 nanometers per second. A carrier gas such as helium generally is used to carry the precursor gas into chamber 13. The resulting thickness of dielectric 19 is between 2000 and 20,000 nanometers, and the density is approximately 250 to 400 micro-grams/cm³.

Typically, increased oxygen flows are detrimental to the formation of silicon dioxide layers. Increased oxygen flow generally increases stress within the silicon dioxide layer thereby reducing the reliability of adjacent metal layers. Also, the silicon dioxide deposition rate is reduced. Consequently, adding oxygen before beginning silicon dioxide deposition typically would be contrary to normal processing techniques. However, it has been found that creating an oxygen plasma prior to initiating dielectric formation does not increase stress in the dielectric.

FIG. 2 illustrates an enlarged cross-sectional portion of semiconductor wafer 11 having dielectric 19 thereon. Dielectric 19 typically includes a base or planarizing dielectric layer 21 that is covered by a subsequently applied dielectric cap layer 22. The method described in FIG. 1 is used to form layers 21 and 22 thereby ensuring a substantially constant density through out each of layers 21 and 22. A via or opening 23 is created through dielectric 19 by multiple etching operations. First, dielectric 19 is isotropically etched to form the upper sloped sidewall portion of opening 23. Subsequently, opening 23 is anisotropically etched to form a small vertical opening through the remainder of dielectric 19. Such shapes typically are used to facilitate completely filling opening 23 with metal in order to form a conductive via or feedthrough.

A plurality of dashed lines 24 and 26 illustrate the effect of non-uniform density dielectric layers. Suppose, for example, that the initial portion of layer 22 has a lower density than the upper portion of layer 21, the isotropic etching of opening 23 would rapidly etch laterally along the interface between layers 21 and 22 as illustrated by dashed lines 24 and 26. In such an example, lines 24 and 26 would have different shapes because the lower portion of layer 22 would have a lower density than the top portion of layer 21, thus, the undesired undercut etching would proceed faster through layer 22 than layer 21. Such undercut or lateral etching would create a discontinuity that could reduce the current carrying capability of metal deposited into opening 23.

However, since layers 21 and 22 were formed by the method described in the description of FIG. 1, layers 21 and 22 each have a uniform density and the undercut illustrated by dashed lines 24 and 26 is not created. Therefore, metal deposited into opening 23 substantially fills opening 23.

By now it should be appreciated that there has been provided a novel method of forming a uniform density dielectric layer on a semiconductor wafer. Initiating and stabilizing a plasma of the activation gas within a deposition chamber prior to initiating deposition ensures that the dielectric layer that is formed has a substantially constant density throughout. Such a dielectric layer substantially eliminates undercutting of the dielectric layer during subsequent etching operations. Additionally, stress within the dielectric layer is not increased and the dielectric's deposition rate is not reduced.

## Claims

1. A method of depositing a dielectric layer comprising:
initiating a plasma of an activation gas wherein the plasma is substantially devoid of other gases;
stabilizing the plasma of the activation gas; and
activating a plasma of a dielectric precursor gas by adding the dielectric precursor gas to the plasma of the activation gas.

2. The method of claim 1 wherein initiating the plasma of the activation gas includes initiating a nitrous oxide plasma.

3. The method of claim 1 wherein initiating the plasma of the activation gas includes initiating an oxygen plasma.

4. The method of claim 1 wherein stabilizing the plasma of the activation gas includes maintaining the plasma of the activation gas for at least two seconds.

5. The method of claim 1 wherein activating the plasma of the dielectric precursor gas includes activating a silicon dioxide precursor gas.

6. The method of claim 1 wherein activating the plasma of the dielectric precursor gas by adding the dielectric precursor gas to the plasma of the activation gas includes forming a tetraethylorthosilicate plasma by adding a tetraethylorthosilicate gas to the plasma of the activation gas.

7. The method of claim 5 wherein activating the silicon dioxide precursor gas includes releasing the silicon dioxide precursor gas into a deposition chamber at a rate of approximately 100 to 300 cubic centimeters/second.

8. The method of claim 1 or 2 or 3 or 5 or 6 wherein activating the plasma of the dielectric precursor gas includes forming the dielectric layer on a semiconductor wafer wherein the dielectric layer has a thickness and a substantially constant density throughout the thickness.
